**Europäisches Patentamt**

**European Patent Office**

**Office européen des brevets**

(11) Veröffentlichungsnummer: **0 463 229 B1**

(12) **EUROPÄISCHE PATENTSCHRIFT**

(45) Veröffentlichungstag der Patentschrift: **07.12.94**

(51) Int. Cl.5: **B22D 27/04**, C30B 11/00

(21) Anmeldenummer: **90123414.6**

(22) Anmeldetag: **06.12.90**

(54) **Verfahren zur Herstellung von gerichtet erstarrten Giessteilen.**

(30) Priorität: **13.06.90 DE 4018924**

(43) Veröffentlichungstag der Anmeldung:
**02.01.92 Patentblatt 92/01**

(45) Bekanntmachung des Hinweises auf die
Patenterteilung:
**07.12.94 Patentblatt 94/49**

(84) Benannte Vertragsstaaten:
**AT BE CH DE FR GB IT LI**

(56) Entgegenhaltungen:
DE-A- 3 323 896
FR-A- 2 445 193
GB-A- 2 229 274
US-A- 4 190 094

PATENT ABSTRACTS OF JAPAN vol. 13, no.
94 (M-804)(3442) 6. März 1989 & JP-A-63 286
267 (KOBE STEEL LTD ) 22. November 1988

(73) Patentinhaber: **LEYBOLD AKTIENGESELL-
SCHAFT
Wilhelm-Rohn-Strasse 25,
Postfach 1555
D-63450 Hanau (DE)**

(72) Erfinder: **Hugo, Franz
Sonnenstrasse 24
63743 Aschaffenburg (DE)**
Erfinder: **Bittenbrünn, Harald
Max-Reger-Strasse 21a
63452 Hanau (DE)**
Erfinder: **Hediger, Fredy, Dr.
Pontdriesch 17
52062 Aachen (DE)**

(74) Vertreter: **Sartorius, Peter, Dipl.-Ing. Patentanwalt
Elisabethenstrasse 24
D-68535 Neckarhausen (DE)**

## Beschreibung

Die Erfindung bezieht sich auf ein verfahren zur HerStellung von gerichtet erstarrten bzw. einkristallinen Gießteilen mit mindestens zwei Meßfühlern für die Erfassung von Temperaturen in Metall- oder Legierungsschmelzen, die sich in einer Gießform befinden, mit einem Thermoelement, das mit einer das Thermoelement umgebenden, hitzebeständigen Ummantelung ausgestattet ist, wobei das Thermoelement in die Schmelze eingefügt wird und die Daten in einem Prozeßrechner gespeichert und durch eine Steuereinheit für den Abzug von ähnlichen Gußteilen benutzt werden.

Es sind bereits Meßfühler zur Erfassung von Temperaturen in Metall- oder Legierungsschmelzen bekannt, die sich in einer Gießform befinden. Das Thermoelement ist mit zwei Schenkeln ausgestattet und weist an der Verbindungsstelle eine Schweißperle auf. Ferner ist das Thermoelement mit einer hitzebeständigen Ummantelung versehen. Die Schweißperle des Thermoelements befindet sich in unmittelbarer Nähe eines ersten Endes der Ummantelung, das mit einem $SiO_2$-freien Füllmittel verschlossen ist, wobei dieses erste Ende der Ummantelung direkt in die Schmelze eingeführt ist, während ein zweites Ende der Ummantelung mit einer Haltevorrichtung in Verbindung steht. Hierdurch soll versucht werden, Temperaturmeßfehler an der Erstarrungsfront zu verringern. Da die Meßfühlerspitze direkt in die Schmelze ragt und in die Gießform eingebaut ist, wird die Empfindlichkeit der Messung vergrößert.

Mit anderen bekannten Methoden werden die einzelnen Parameter empirisch ermittelt. Nach einer derartigen Methode wird dann nach dem Abguß das Probegußstück aufgeschnitten, um festzustellen, ob beim Abguß und beim Abziehen des Gußstücks aus der Heizzone mit den richtigen Abzugsparametern die gezielte Erstarrung herbeigeführt worden ist. Mit den empirisch ermittelten Abzugsparametern werden dann weitere Gußstücke hergestellt. Um auf diese Weise zuverlässige Parameter zu erhalten, sind sehr lange Entwicklungszeiten notwendig, die bis zu einem halben Jahr und mehr in Anspruch nehmen können.

Ferner ist ein Verfahren zur Herstellung von gerichtet erstarrten Gußteilen der eingangs aufgeführten Art bekannt (US 4 190 094), in dem das Abzugsgeschwindigkeitsprofil eines Prüfgußteils ermittelt wird. Nach dieser Druckschrift ist es bekannt, die Daten einem Prozeßrechner zuzuführen, die in diesem gespeichert werden und durch eine Steuereinheit für den Abzug von ähnlichen Gußteilen benutzt werden. Mit diesem bekannten Verfahren erfolgt jedoch keine Erfassung der Phasengrenzlage. Aus den gemessenen Signalen kann die Lage der Phasengrenze im Gußteil überhaupt nicht bestimmt werden. Die Phasenparameter, also Abzugsgeschwindigkeit und Ofentemperaturen, müssen somit durch sehr aufwendige Versuche empirisch bestimmt werden.

Die gleichen Nachteile weist auch das Verfahren zur Herstellung von gerichtet erstarrten Gußteilen nach der FR-A-2 445 193 auf. Nach dieser Druckschrift ist es lediglich bekannt, ein Thermoelement in eine Schmelze einzuführen und über eine Steuereinheit mit einem Heizungstemperaturregler zu verbinden. Auch mit diesem Verfahren erfolgt keine Erfassung der Phasengrenzlage, und die Daten werden ebenfalls nicht gespeichert, um die Abzugsgeschwindigkeit zu regeln.

Hier will die Erfindung Abhilfe schaffen. Die Erfindung, wie sie in den Ansprüchen gekennzeichnet ist, löst die Aufgabe dadurch, daß die Lage der Phasengrenze zwischen Liquidus und Solidus aus den gemessenen Temperaturen durch eine Interpolationsrechnung ermittelt wird und daß die Abzugsgeschwindigkeit des Gießteils so geregelt wird, daß die Phasengrenze während des Abzugs des Gießteils stets in dem gewünschten Bereich der Isolation etwas oberhalb des Kühlkopfes verharrt.

Gemäß einem besonderen Merkmal der erfindungsgemäßen Lösung ist schließlich vorgesehen, daß die Anlage zur Herstellung von gerichtet erstarrten bzw. einkristallinen Gießteilen mindestens einen Heizungstemperaturregler zur Regelung der Heizungstemperatur in Abhängigkeit der jeweiligen Position der Gießform im Vakuumofen aufweist, wobei die Anlage zur Herstellung von gerichtet erstarrten bzw. einkristallinen Gießteilen mit einer Temperaturkurvenscheibe und mit einem mit einem Rechner zusammenwirkenden Schreiber ausgerüstet ist, mit denen die Abzugsgeschwindigkeit der Gießform aus der Heizzone gesteuert wird.

Dieses Heizungstemperaturprofil als Funktion der jeweiligen Stellung der Gießform im Vakuumofen in Verbindung mit der Abzugsgeschwindigkeit der Gießform steht dann für weitere Gießvorgänge in Verbindung mit dem Abzugsgeschwindigkeitsprofil als reproduzierbare Größe für nachfolgende Gießvorgänge zur Verfügung.

Mit dem erfindungsgemäßen Verfahren zur Herstellung von gerichtet erstarrten bzw. einkristallinen Gießteilen, beispielsweise Turbinenschaufeln, ist es auf einfache Weise möglich, zuerst die Thermoelemente in die Schmelze einzuführen. Dann wird mittels der ermittelten Parameter und durch Interpolationsrechnung die Phasengrenze ermittelt. Hierdurch ist es möglich, die Abzugsgeschwindigkeit so zu regeln, daß die Phasengrenze stets in dem gewünschten Bereich bzw. in dem optimalen Bereich liegt, d. h. etwas oberhalb des Kühlkopfes verharrt. Das Abzugsgeschwindigkeitsprofil wird dann gespeichert und steht mit seinen Parametern für gleiche Gießprozesse zur Verfügung, d. h. der nächste Gießvorgang kann dann unter Berücksichtigung des Abzugsgeschwindigkeitsprofils ohne Einsatz der Thermoelemente beliebig oft für den gleichen Gießvorgang wiederholt werden. Komplizierte, zeitraubende Rechenprozesse bzw. lange Versuchsreihen können entfallen. Das Abzugsgeschwindigkeitsprofil läßt sich auch in vorteilhafter Weise als Kurvenscheibe zur Steuerung der Abzugsgeschwindigkeit der Gießform darstellen.

Weitere Merkmale der Erfindung sind in der Beschreibung der Figuren dargestellt, wobei bemerkt wird, daß alle Einzelmerkmale und alle Kombinationen von Einzelmerkmalen erfindungswesentlich sind.

In den Figuren ist die Erfindung an einer Ausführungsform beispielsweise dargestellt, ohne auf diese Ausführungsform beschränkt zu sein. Es zeigt:

Figur 1
einen Vakuumofen mit einer Graphitheizung,
Figur 2
Haltekapillaren und Meßkapillaren, die an eine Formschale anschließen,
Figur 3
ein mit einem Keramikrohr ummanteltes Thermoelement,
Figur 3a bis 4c
Ein mit einem Keramikrohr ummanteltes Thermoelement sowie die Einführung des Thermoelements in ein Keramikrohr,
Figur 5
die Prozeßsteuerungsanlage,
Figur 6
eine schematische Darstellung der Geometrieverhältnisse des Abgußofens mit der Heizzone $H_2$, $H_1$ mit der adiabaten Zone A sowie der Kühlzone K, in der eine gekühlte Kupferplatte angeordnet ist,
Figur 7
eine schematische Schnittdarstellung der Gießform mit Solidus und Liquiduszone im Teilschnitt und perspektivischer Darstellung,
Figur 8 und 9
die Weg-Position der Gießform im Heizofen.

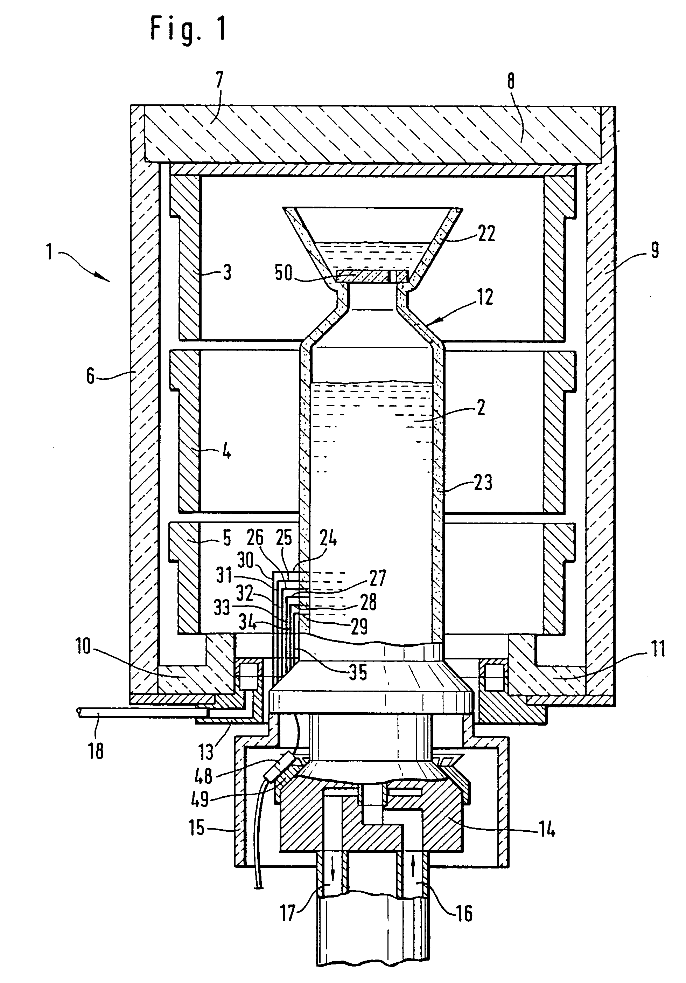

In der Figur 1 ist eine geschnittene Seitenansicht eines Vakuumofens 1 für die gerichtete Erstarrung einer Schmelze 2 dargestellt. Dieser Vakuumofen 1 weist drei zylindermantelförmige Graphitheizelemente 3, 4, 5 auf, die durch eine Isolation 6 - 11 vor Wärmeverlusten geschützt wird. Zwischen den Heizelementen 3, 4, 5 sind aus isolationstechnischen Gründen Lücken vorgesehen. Die elektrischen Anschlüsse der Heizelemente 3, 4, 5 sind in der Fig. 1 nicht dargestellt. Die Heizelemente sind deshalb erforderlich, um die Schmelze flüssig zu halten und durch einen möglichst eindimensionalen Wärmefluß eine gerichtete Erstarrung der Schmelze zu bewirken. Um den für die Erstarrung der Schmelze 2 erforderlichen Temperaturgradienten zu erzeugen, ist eine Leitwand 13 neben und unterhalb des Isolationsbereichs 10 vorgesehen. In dieser Leitwand 13 kann sich ein Kühlkopf 14 vertikal frei bewegen, der von einem Hitzeschild 15 umgeben ist. Der Kühlkopf 14 weist eine zuführende und eine abführende Wasserleitung 16 bzw. 17 auf, durch welche als Kühlmittel Wasser strömt. Ein weiteres zuführendes Wasserkühlrohr 18 ist innerhalb der Leitwand 13 und unterhalb des Isolationsbereichs 10 vorgesehen. Das entsprechende abführende Wasserkühlrohr ist in der Fig. 1 nicht zu erkennen, da es von dem Wasserkühlrohr 18 verdeckt ist. Die Kühlung über das Wasserkühlrohr 18 ist erforderlich, damit dann, wenn die Formschale 12 abgesenkt wird, der Temperaturgradient durch Abstrahlen der Wärme von der Formschale 12 erhalten bleibt, da der Kühlkopf 14 in diesem Fall keine Wirkung mehr hat. Der Kühlkopf 14 hat lediglich in der Anfangsphase der Erstarrung einen Einfluß auf den Wärmehaushalt der Schmelze 2.

Die Schmelze 2 wird entweder direkt oder mittels eines in der Zeichnung nicht dargestellten Eingießtrichters, der ein relativ langes Rohr mit einer kleinen Öffnung aufweist, in eine Gießform bzw. Formschale 12 gegossen, die aus einem oberen trichterförmigen Gebilde 22 und einem unteren Rohr 23 besteht, das oberhalb des Kühlkopfes 14 angeordnet ist. Es ist außerdem möglich, den Eingießtrichter wegzulassen und direkt in die Gießform einzugießen. Zwischen dem trichterförmigen Gebilde 22 und dem Rohr ist ein Keramikfilter 50 angeordnet, der nach dem Eingießen der Schmelze 2 noch mit dieser Schmelze 2 bedeckt ist. Statt eines Rohrs 23 kann auch eine Gießform vorgesehen werden, die beliebige andere Geometrien aufweist, beispielsweise die Geometrie einer Turbinenschaufel. Die Gießform oder Formschale 12 besteht vorzugsweise aus einer Keramikmasse, die nach dem Gießvorgang zerstört wird.

Die für die vorliegende Erfindung wesentlichen Thermoelementdrähte befinden sich innerhalb von Meßkapillaren 24 - 29 und Haltekapillaren 30 - 35, durch welche sie vor einer aggressiven Ofenatmosphäre geschützt sind. Mit Hilfe dieser Vielzahl von Thermoelementen wird die Temperatur der Erstarrungsfront der Schmelze 2 erfaßt. Der Abgriff der Thermospannungen erfolgt mittels Ausgleichsleitungen 47. Diese werden durch den Hitzeschild 15 vor der Wärmestrahlung der Heizelemente 3, 4, 5 geschützt und sind über Kunststoffsteckverbindungen 48 an einer Zugentlastung 49 befestigt. In der Fig. 1 ist zwar nur eine Kunststoffsteckverbindung 48 dargestellt, doch ist in der Praxis für jedes Thermoelement eine eigene Steckverbindung und eine eigene Ausgleichsleitung vorgesehen, die zu einer nicht dargestellten Auswerteinrichtung führen. In der Fig. 1 sind auch nur einige der Meß- und Haltekapillaren gezeigt. In der Praxis können noch weitaus mehr Meß- und Haltekapillaren vorgesehen werden.

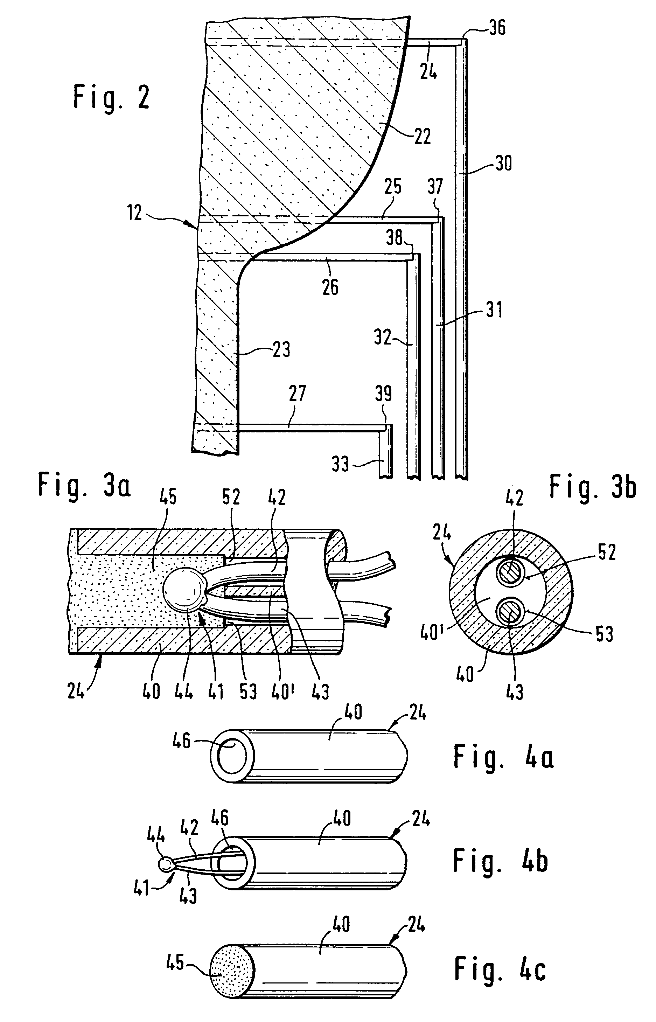

In der Fig. 2 sind die Meßkapillaren 24 - 27 sowie die Haltekapillaren 30 - 33, welche die Thermoelement-Schenkel einschließen, noch einmal in vergrößertem Maßstab dargestellt. Der obere Teil 22 der Formschale 12 ist ebenfalls erkennbar. Während in der Fig. 1 die Heranführung der Thermoelemente an den unteren Teil 23 der Formschale 12 dargestellt ist, zeigt die Fig. 2 die Heranführung der Thermoelemente an den oberen Teil 22 dieser Formschale 12. Mit 36 - 39 sind die Stellen bezeichnet, an denen die Thermoelement-Drähte geknickt sind. An diesen Stellen 36 - 39 ist ein Feuerfestkitt vorgesehen, der die Thermoschenkel des Thermoelements hermetisch abdichtet. Um die Meßkapillaren 24 - 27 zusätzlich zu unterstützen, werden die oberen Enden der Haltekapillaren 30 - 33 rechtwinklig angeschliffen.

Die Fig. 3a zeigt einen teilweisen Schnitt durch eine Meßkapillare 24, die beispielsweise aus Keramik besteht. In dieser Keramikkapillare 24 befindet sich ein Thermoelement 41, das aus zwei Thermoschenkeln 42, 43 und einer Löt- oder Schweißstelle 44 besteht. Der vordere Teil der Thermoschenkel 42, 43 sowie die Schweißstelle 44 sind in einen Kleber 45 eingetaucht. Die Meßkapillare 24 wird nicht mehr ummantelt, was einen entscheidenden Vorteil der Erfindung darstellt.

Eine Ansicht auf die Keramikkapillare 24 mit den beiden Thermoschenkeln 42, 43 ist in der Fig. 3b dargestellt. Bei einer konkreten Ausführungsform der Meßkapillare 24 hat ein Thermoschenkel beispielsweise einen Außendurchmesser von 0,1 mm, während die Kapillare 24 einen Außendurchmesser von 0,9 mm aufweist und mit zwei Bohrungen 52, 53 versehen ist, die jeweils einen Innendurchmesser von 0,2 mm haben. Der Sacklochdurchmesser beträgt hierbei 0,5 mm und die Sacklochtiefe 1,0 mm. Die elektrische Isolation der Thermoschenkel 42, 43 erfolgt durch den Isolationskörper 40'. Auf entsprechende Weise werden die Thermoschenkel 42, 43 auch in den Haltekapillaren elektrisch voneinander getrennt.

In den Figuren 4a bis 4c ist das Verfahren verdeutlicht, nach dem das Thermoelement 41 in die Keramikkapillare 24 eingeführt wird.

Die Fig. 4a zeigt einen Teil der Keramikkapillare 24, die eine vordere Öffnung 46 sowie eine in der Fig. 4a nicht sichtbare hintere Öffnung aufweist. Da die Keramikkapillare 24 zwei Bohrungen 52, 53 aufweist, wird sie auch oft Zweilochkeramikrohr genannt. Bei der vorderen Öffnung 46 ist bereits der Isolationskörper 40' bis zu einer bestimmten Tiefe weggebohrt, d.h. es ist ein Sackloch vorgesehen.

In der Fig. 4b ist dargestellt, wie das Thermoelement 41 in die Keramikkapillare 24 eingeführt wird. Da die Kapillare 24, in die die beiden Thermoschenkel 42, 43 eingeführt wurden, an der Spitze bereits mit einer Bohrmaschine angebohrt worden war, so daß ein Sackloch entstand, kann die Schweißperle 44 der beiden Schenkel 42, 43 aufgenommen werden. Das Anbohren der Kapillare 24 kann auf verschiedene Weise durchgeführt werden, beispielsweise durch Diamantbohren, Ultraschallbohren oder Laserstrahlbohren.

Die Fig. 4c zeigt, wie nach Einziehen des Thermoelements 41 in das Keramikrohr 40 das Ende des Keramikrohrs 40 mit dem Kleber 45 aufgefüllt und verschlossen wird. Möglich ist auch ein Verschweißen des Rohrs 40, beispielsweise mit Hilfe eines Wasserstoff- oder Acethylenbrenners, eines Lichtbogens oder eines Laserstrahls. Durch diese Maßnahme wird das Thermoelement so hinreichend von seiner Umgebung isoliert, daß es eine hohe Standzeit gegen aggressive Schmelzen hat. Bei Verwendung eines Klebers ist kein Schweißgerät notwendig, wodurch keine thermische Belastung der Kapillarspitze bzw. des Thermodrahts mit der Schweißperle 44 auftritt. Der Vorteil des Schweißens besteht darin, daß die Kapillare mit arteigenem Material verschlossen werden kann.

Im folgenden wird die Funktion der erfindungsgemäßen Einrichtung beschrieben.

Das in einem Ofen, beispielsweise einem Elektroofen, geschmolzene Metall bzw. eine geschmolzene Legierung kann mittels einer nicht dargestellten Vorrichtung in den Eingießtrichter gegeben, von wo aus es durch das Rohr in die Formschale 12 sinkt. Da sich am Boden der Formschale 12 der Kühlkopf 14 befindet, entsteht zwischen der Formschale 12 und dem Kühlkopf 14 eine große Temperaturdifferenz. Diese Temperaturdifferenz bewirkt, daß das geschmolzene Metall bzw. die geschmolzene Legierung von unten nach oben erstarrt. Mit Hilfe der Erfindung ist es möglich, den Verlauf dieser Erstarrungsfront festzustellen und hierdurch Rückschlüsse auf die Erstarrungsbedingungen während des Prozeßverlaufs zu ziehen. Hierdurch sind auch Rückschlüsse auf die Eigenschaften des gegossenen Bauteils möglich.

Die Keramikkapillare 24 sowie das Thermoelement 41 werden während der gerichteten Erstarrung, die von unten nach oben erfolgt, in der erstarrenden Schmelze 2 fixiert und können somit nicht mehr aus dem Metall bzw. der Legierung entfernt werden.

Bei Messungen mittels zahlreicher Meßfühler werden alle Meßkapillaren 24 - 29, Haltekapillaren 30 - 35, Thermodrähte 42, 43 und Stecker 48 fertig konfektioniert. Die Spitzen der Meßkapillaren 24 - 29 werden sodann in vorgefertigten Bohrungen in der Formschale 12 mit Hilfe eines Keramikklebers 45 befestigt.

Dadurch, daß die Meßfühler sehr klein sind, kann das Kristallwachstum von Schmelzen leicht ermittelt werden, denn die Meßfühler werden direkt in die Schmelze eingeführt, ohne daß hierdurch das Kristallwachstum beeinflußt wird. Für die Erfassung der Temperaturgradienten ist es sehr wichtig, daß die Meßfühler nur eine geringe Größe haben.

Es ist besonders vorteilhaft, wenn die Phasengrenze eben ist, d.h. an einer Stelle, an der kein radialer Wärmefluß auftritt. Die liegt deshalb auch oberhalb des wassergekühlten Kühlkopfes 14 im Isolationsbereich 10. Wird beispielsweise die Gießform zu schnell nach unten bewegt, so wandert die Phasengrenze nach unten heraus. Wird dagegen die Gießform zu langsam nach unten bewegt, so wandert die Phasengrenze in den Ofenraumbereich $H_1$ nach oben, so daß sie dann nicht mehr eben verläuft. Deshalb ist es vorteilhaft, wenn die Phase stets etwas oberhalb des Kühlrings 14, also im Isolationsbereich verläuft um die Phasenfläche eben bzw. horizontal zu halten.

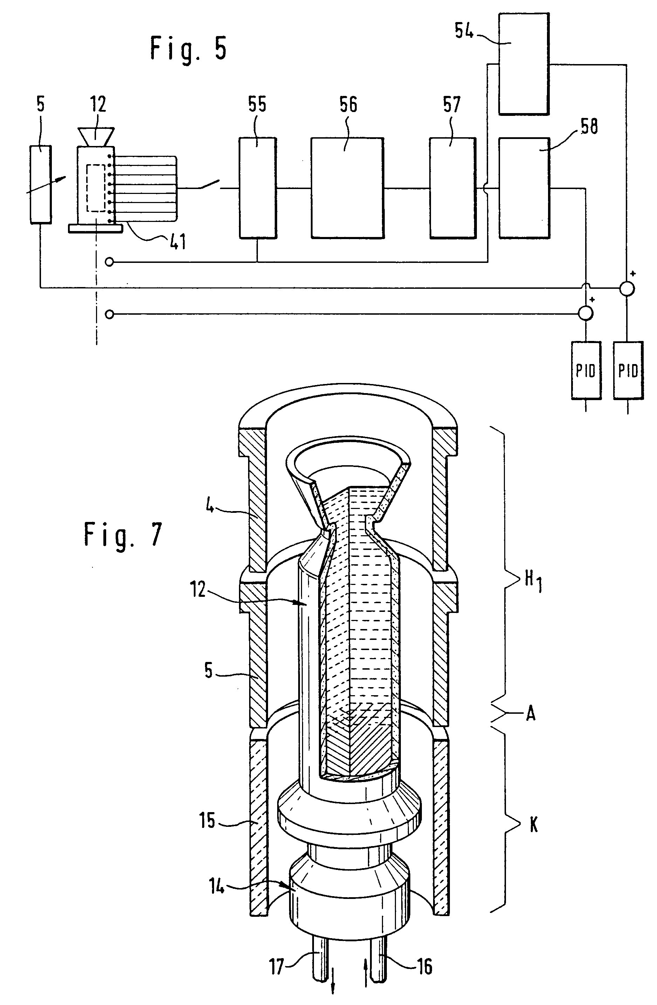

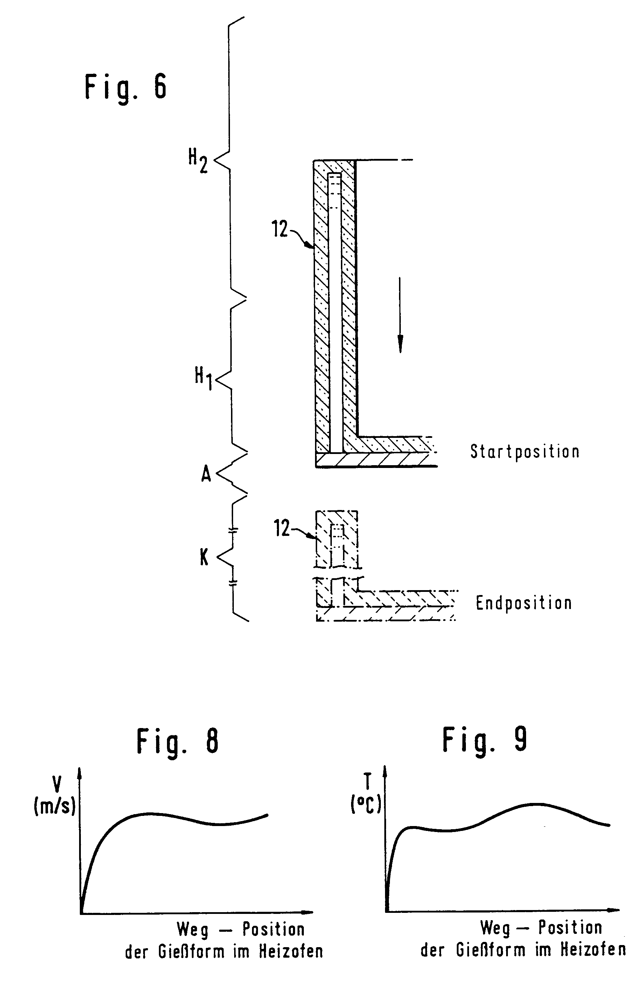

Bei dem erfindungsgemäßen Verfahren zur Herstellung von gerichtet erstarrten bzw. einkristallinen Gießteilen, beispielsweise Turbinenschaufeln, werden zuerst die Thermoelemente 41 in die Schmelze eingeführt (Figur 1, 5), dann wird die Phasengrenze mittels einer Interpolationsrechnung ermittelt und anschließend die Abzugsgeschwindigkeit so geregelt, daß die Phasengrenze stets in dem gewünschten Bereich, d.h. etwas oberhalb des Kühlkopfes 14 verharrt. Das Abzugsgeschwindigkeitsprofil wird dann gespeichert. Das Abzugsgeschwindigkeitsprofil steht mit seinen Parametern für gleiche Gießprozesse zur Verfügung, d.h. der nächste Gießvorgang kann dann unter Berücksichtigung des Abzugsgeschwindigkeitsprofils ohne Einsatz der Thermoelemente beliebig oft für den gleichen Gießvorgang wiederholt werden. Komplizierte, zeitraubende Rechenprozesse bzw. lange Versuchsreihen können entfallen.

Besonders vorteilhaft ist es, daß die Anlage zur Durchführung des Verfahrens zur Herstellung von gerichtet erstarrten bzw. einkristallinen Gießteilen mindestens einen oder mehrere Meßfühler bzw. Meßkapillaren 24 bis 30 für die Erfassung von Temperaturen in Metall- oder Legierungsschmelzen aufweist. Hierzu gehört ferner eine Datenacquisition 55, ein Prozeßrechner 56, eine Steuereinheit 57 für die Steuerung des Abzugs der Gießform aus der Heizzone 1 bzw. 2 sowie eine Datenerfassungseinrichtung 58 zur Speicherung aller Daten insbesondere des Abzugsgeschwindigkeitsprofils über der Zeit (V = ft) und zur Datenerfassung der Heizungstemperatur als Funktion des zurückgelegten Wegs der Gießform aus der Heizzone (T C° f der Position des Gießform im Heizofen).

Außerdem weist die Anlage zur Herstellung von gerichtet erstarrten bzw. einkristallinen Gießteilen mindestens einen Heizungstemperaturregler 54 zur Regelung der Heizungstemperatur in Abhängigkeit der jeweiligen Position der Gießform im Vakuumofen 1 auf (Figur 5,8, 9).

Im Prozeßrechner erfolgt bei der Erstellung der ersten Gießform eine Abspeicherung der Sollwerte bzw. der ermittelten Heizungstemperaturen mit Bezug auf die jeweilige Stellung der Gießform im Vakuumofen. Dieses Temperaturprofil mit Bezug auf die Gießformposition wird als Parameter vorgegeben, der sich wiederum aus dem Profil der Gießform z.B. einer Turbinenschaufel ergibt. Die Abzugsgeschwindigkeit der Gießform aus dem Vakuumofen 1 wird während der Erstellung der ersten Schmelze ermittelt, wobei dafür Sorge getragen wird, daß die Erstarrungsfront stets in einer bestimmten Position gehalten wird. Dieser Geschwindigkeitsverlauf, d.h. die Abzugsgeschwindigkeit, wird ebenfalls in einem Rechner abgespeichert (Figur 8). Die auf diese Weise ermittelten Parameter stehen für nachfolgende Gießprozesse zur Verfügung.

Bezugzeichenliste

| | |
|---|---|
| 1 | Vakuumofen |
| 2 | Schmelze |
| 3 | Graphitheizelement |
| 4 | Graphitheizelement |
| 5 | Graphitheizelement |
| 6 | Isolation |
| 7 | Isolation |
| 8 | Isolation |
| 9 | Isolation |
| 10 | Isolation /Isolationsbereich |
| 11 | Isolation |
| 12 | Formschale |
| 13 | Leitwand |
| 14 | Kühlkopf |
| 15 | Hitzeschild |
| 16 | Wasserleitung |
| 17 | Wasserleitung |
| 18 | Kühlrohr |
| 22 | Gebilde |
| 23 | Rohr |
| 24 | Meßkapillare |
| 25 | Meßkapillare |
| 26 | Meßkapillare |
| 27 | Meßkapillare |
| 28 | Meßkapillare |
| 29 | Meßkapillare |
| 30 | Meßkapillare |
| 31 | Meßkapillare |
| 32 | Meßkapillare |
| 33 | Meßkapillare |
| 34 | Meßkapillare |

| | |
|---|---|
| 35 | Meßkapillare |
| 36 | Stelle |
| 37 | Stelle |
| 38 | Stelle |
| 39 | Stelle |
| 40 | Rohr |
| 40 | Kunststoffsteckverbindunng |
| 40' | Isolationskörper |
| 41 | Thermoelement |
| 42 | Thermoschenkel |
| 43 | Thermoschenkel |
| 44 | Schweißstelle /Schweißperle |
| 45 | Kleber |
| 46 | Öffnung |
| 47 | Ausgleichsleitung |
| 48 | Kunststoffsteckverbindung |
| 49 | Zugentlastung |
| 50 | Keramikfilter |
| 52 | Bohrung |
| 53 | Bohrung |
| 54 | Temperaturregler |
| 55 | Datenacquisition |
| 56 | Prozeßrechner |
| 57 | Steuereinheit |
| 58 | Datenspeicher |

**Patentansprüche**

1. Verfahren zur Herstellung von gerichtet erstarrten bzw. einkristallinen Gießteilen mit mindestens zwei Meßfühlern für die Erfassung von Temperaturen in Metall- oder Legierungsschmelzen, die sich in einer Gießform befinden, mit einem Thermoelement, das mit einer das Thermoelement umgebenden, hitzebeständigen Ummantelung ausgestattet ist, wobei das Thermoelement in die Schmelze eingefügt wird und die Daten in einem Prozeßrechner gespeichert und durch eine Steuereinheit für den Abzug von ähnlichen Gußteilen benutzt werden, **gekennzeichnet durch** folgende Verfahrensschritte:

   a) die Lage der Phasengrenze zwischen Liquidus und Solidus wird aus den gemessenen Temperaturen durch eine Interpolationsrechnung ermittelt,

   b) die Abzugsgeschwindigkeit des Gießteils wird so geregelt, daß die Phasengrenze während des Abzugs des Gießteils stets in dem gewünschten Bereich der Isolation (10) etwas oberhalb des Kühlkopfes (14) verharrt.

2. Verfahren nach Anspruch 1, dadurch gekennzeichnet, daß das Abzugsgeschwindigkeitsprofil über der Zeit (V = ft) in einem Rechner gespeichert und mit seinen Parametern für weitere Gießprozesse von Gußteilen gleicher bzw. annähernd gleicher Geometrie zusammen mit der Sollwertfunktion für die Heizungstemperatur als Sollwertsatz für temperaturgeregeltes und/oder geschwindigkeitgeregeltes Abziehen zur Verfügung gestellt wird .

3. Vorrichtung zur Durchführung des Verfahrens nach Anspruch 1 zur Herstellung von gerichtet erstarrten bzw. einkristallinen Gießteilen, die einen Vakuumofen (1) und eine Geißform (12) aufweist mit mindestens zwei Meßfühlern (24-29) für die Erfassung von Temperaturen in Metall- oder Legierungsschmelzen (2) aus einer Datenacquisition (55), einem Prozeßrechner (56), einer Steuereinheit (57) für die Steuerung des Abzugs der Gießform aus den Heizelementen (3, 4, 5) sowie einer Datenerfassungseinrichtung (58) zur Speicherung aller Daten, insbesondere des Abzugsgeschwindigkeitsprofils über der Zeit (V = ft) und/oder der Funktion des Wegs der Gießform, und zur Datenerfassung der Heizungstemperatur als Funktion des zurückgelegten Wegs der Gießform aus der Heizzone, wobei dem Vakuumofen ein Kühlkopf (14) zugeordnet ist, der von einem Hitzeschild (15) umgeben ist, **dadurch gekennzeichnet,** daß die Anlage zur Herstellung von gerichtet erstarrten bzw. einkristallinen Gießteilen mindestens einen Heizungstemperaturregler (54) zur Regelung der Heizungstemperatur in Abhängigkeit der jeweiligen Position der Gießform im Vakuumofen (1) aufweist, wobei die Anlage zur Herstellung von einkristallinen Gießteilen mit einer Temperaturkurvenscheibe und mit einem mit einem Rechner zusammenwirkenden Schreiber ausgerüstet ist, mit denen die Abzugsgeschwindigkeit der Gießform aus der Heizzone gesteuert wird.

**Claims**

1. Method of manufacturing directionally solidified or monocrystalline castings including at least two sensors for sensing temperatures in metal or alloy melts contained in a mould, and further including a thermoelement equipped with a heat resistant coating, said thermoelement being introduced into the melt, and the data being stored in a process computer and used, by means of a control unit, for the withdrawal of similar castings, characterized by the following operational steps:

   a) the position of the liquid/solid interphase is determined from the measured temperatures by means of interpolation,

   b) the withdrawal speed of the casting is controlled such that during the withdrawal of the casting, the interface is always located in the desired area of the insulation (10) slightly above the cooling head 14.

2. Method in accordance with claim 1, characterized in that the withdrawal speed profile over time (V = ft) is stored in a computer and thus is available with its parameters for the further casting of parts of the same or approximately the same geometry together with the function of the desired value for the heating temperature as a set of desired values for a temperature-controlled and/or speed-controlled withdrawal.

3. Device for performing the method in accordance with claim 1 for the manufacture of directionally solidified or monocrystalline castings comprising a vacuum furnace (1) and a mould (12), and further comprising at least two sensors (24-29) for sensing temperatures in metal and alloy melts (2), a data acquisition (55), a process computer (56), a control unit (57) for controlling the withdrawal of the mould from the heating elements (3, 4, 5) and a data acquisition unit (58) for storing all data, particularly the withdrawal speed profile over time (V = ft) and/or the function of the distance covered by the mould and for storing the data of the heating temperature as a function of the distance covered by the mould leaving the heating zone, the vacuum furnace being equipped with a cooling head (14) surrounded by a thermal shield (15), characterized in that the device for the manufacture of directionally solidified or monocrystalline castings comprises at least one heating temperature control (54) for controlling the heating temperature in dependency upon the respective position of the mould in the vacuum furnace (1), said device for the manufacture of monocrystalline castings being further provided with a temperature cam disc and with a recorder which cooperates with a computer, by means of which the withdrawal speed of the mould from the heating zone is controlled.

**Revendications**

1. Procédé pour la préparation de pièces coulées par solidification dirigée ou monocristallines avec au moins deux sondes pour la mesure des températures dans des métaux ou alliages fondus se trouvant dans un moule, avec un thermocouple doté d'une enveloppe résistante à la chaleur, ce thermocouple étant introduit dans la masse fondue et les données étant mémorisées dans un calculateur et utilisées, par l'intermédiaire d'une unité de commande, pour l'extraction de pièces coulées similaires, caractérisé par les étapes suivantes:

a) la position de l'interphase liquide/solide est déterminée par interpolation à partir des températures mesurées,

b) la vitesse d'extraction du four de la pièce coulée est réglée de sorte que, lors de l'extraction de la pièce coulée, l'interphase se trouve constamment dans la zone d'isolation désirée située légèrement au-dessus de la tête de refroidissement (14).

2. Procédé suivant la revendication 1, caractérisé en ce que le profil de vitesse d'extraction dans le temps (V = ft) est mémorisé dans un ordinateur et disponible avec ses paramètres pour la coulée d'autres pièces coulées d'une géométrie identique ou similaire, avec la fonction de la valeur de consigne pour la température de chauffe en tant que jeu de valeurs de consigne pour l'extraction du four à température et/ou vitesse contrôlées.

3. Dispositif pour la mise en oeuvre du procédé selon la revendication 1 pour la préparation de pièces coulées par solidification dirigée ou monocristallines, comportant un four à vide (1) et un moule (12) avec au moins deux sondes (24 - 29) pour la mesure des températures dans des métaux ou alliages fondus (2), une acquisition des données (55), un calculateur (56), une unité de commande (57) destinée à contrôler l'extraction du moule des éléments de chauffe (3, 4, 5) ainsi qu'un dispositif de saisie des données (58) pour la mémorisation de l'ensemble des données, en particulier du profil de la vitesse d'extraction dans le temps (V = ft) et/ou de la fonction du cheminement du moule, et pour la saisie des données de la température de chauffe en fonction du cheminement parcouru par le moule en quittant la zone de chauffage, le four à vide comportant une tête de refroidissement (14) entourée par un écran thermique (15), caractérisé en ce que l'installation pour la préparation de pièces coulées par solidification dirigée ou monocristallines présente au moins un thermorégulateur (54) réglant la température de chauffe en fonction de la position respective du moule dans le four à vide (1), l'installation pour la préparation de pièces coulées monocristallines étant équipée d'une came de température et d'un enregistreur interconnecté à un ordinateur, l'ensemble de ces dispositifs servant à régler la vitesse d'extraction du moule de la zone de chauffe.

# Fig. 1

Fig. 2

Fig. 3a

Fig. 3b

Fig. 4a

Fig. 4b

Fig. 4c

Fig. 5

Fig. 7

# Fig. 6

$H_2$

12

Startposition

$H_1$

A

12

K

Endposition

# Fig. 8

V
(m/s)

Weg — Position
der Gießform im Heizofen

# Fig. 9

T
(°C)

Weg — Position
der Gießform im Heizofen